# EUROPÄISCHE PATENTANMELDUNG

(11) **EP 2 006 674 A1**
(43) Veröffentlichungstag der Anmeldung: **24.12.2008**
(21) Anmeldenummer: 08008003.9
(22) Anmeldetag: 25.04.2008
(51) Int. Cl.: G01N 27/76

(54) **Sauerstoffmesszelle**

(30) Priorität: 19.06.2007 DE 102007028147
(71) Anmelder: M & C TechGroup Germany GmbH, 40885 Ratingen (DE)
(72) Erfinder:
(74) Vertreter: Berkenbrink, Kai-Oliver

(57) **Zusammenfassung**

Sauerstoffmesszelle zur paramagnetischen Sauerstoffbestimmung, also zur Messung des Sauerstoffanteils in einem Gas, mit einer Messkammer (22), einem in der Messkammer angeordneten hantelförmigen Drehteil (63) mit zwei stickstoffgefüllten Hohlkörpern, einer Einrichtung zur Erzeugung eines ungleichförmigen Magnetfeldes, einer Einrichtung (66,56,68a,68b) zur optischen Messung der Drehung des Drehteils, und einer Einrichtung (27) zur Messung des Gasdurchflusses in der Messkammer.

## Beschreibung

Die Erfindung betrifft eine Sauerstoffmesszelle zur paramagnetischen Sauerstoffbestimmung, also zur Messung des Sauerstoffanteils in einem Gas.

Zur Messung des Sauerstoffanteils in einem Gas wird dabei die unterschiedliche magnetische Suszeptibilität von Sauerstoff und Stickstoff ausgenutzt. Sauerstoff hat eine Suszeptibilität > 0 und ist damit paramagnetisch. Aufgrund dieser paramagnetischer Eigenschaft richten sich die Sauerstoffmoleküle in einem Magnetfeld aus und verstärken damit das Magnetfeld. Stickstoff hingegen hat eine Suszeptibilität < 0, womit es sich bei Stickstoff um einen diamagnetischen Stoff handelt. Stickstoff hat somit die Tendenz, aus einem Magnetfeld herauszuwandern und strebt in einem Magnetfeld damit in Richtung der niedrigeren Feldstärke.

Um diese unterschiedliche Suszeptibilität von Sauerstoff und Stickstoff zur Messung des Sauerstoffanteils in einem Gas auszunutzen, wird in einer Messkammer einer Sauerstoffmesszelle der vorgenannten Art ein ungleichförmiges Magnetfeld erzeugt. Wird nunmehr Sauerstoff enthaltendes Gas durch die Messkammer geleitet, wird das Magnetfeld durch den Sauerstoff verstärkt. Ein in der Messkammer drehbar angeordnetes Drehteil mit stickstoffgefüllten Gasballons strebt daraufhin verstärkt in Richtung der niedrigeren Feldstärke des ungleichförmigen Magnetfeldes. Das Drehteil wird dadurch aus seiner Nullstellung ausgelenkt. Das auf diese Weise erzeugte Drehmoment ist dem Sauerstoffgehalt des durch die Messkammer strömenden, zu analysierenden Gases direkt proportional.

Es ist bekannt, das durch den Sauerstoffanteil erzeugte Drehmoment des Drehteils durch das Magnetfeld einer Leiterschleife zu kompensieren, die geeignet in der Messkammer angeordnet ist und von einem elektrischen Strom durchflossen wird. Bei einer bestimmten Stromstärke wird das durch den Sauerstoffanteil des zu analysierenden Gases hervorgerufene Drehmoment genau kompensiert und das Drehteil befindet sich wieder in seiner Nullstellung. Damit ist der durch die Leiterschleife fließende Kompensationsstrom beziehungsweise die an die Leiterschleife angelegte Spannung ein Maß für das vom Sauerstoffgehalt des zu analysierenden Gases hervorgerufene Drehmoment und damit ein Maß für den Sauerstoffgehalt des Gases.

Die Nullstellung beziehungsweise Ausgangsstellung des Drehteils wird mit Hilfe eines Photosensors kontrolliert. Dazu wird ein Lichtstrahl erzeugt und von außen in die Messkammer geleitet. Von einem in der Mitte des Drehteils angebrachten kleinen Spiegel wird der Lichtstrahl reflektiert und wieder nach außen geleitet. Der Photosensor ist derart angeordnet, dass der reflektierte Lichtstrahl auf diesen leitbar ist. Die Nullstellung des Drehteils ist hierdurch mittels des Photosensors überprüfbar beziehungsweise bestimmbar.

Eine solche Sauerstoffmesszelle ist beispielsweise aus DE 36 33 750 C2 bekannt.

Zur Durchführung einer einwandfreien Sauerstoffmessung in der Sauerstoffmesszelle ist es vielfach notwendig, den Gasdruck des zu messenden Gases zu bestimmen. Da sich der Gasdruck, insbesondere bei wechselnden Prozessdrücken, häufig kurzfristig ändert, ist vielfach eine ständige Bestimmung des Gasdrucks notwendig.

Sauerstoffmesszellen der vorgenannten Art werden insbesondere zur in-line-Messung des Sauerstoffanteils in Gasströmen eingesetzt. Zur Bestimmung des Sauerstoffanteils in Gasströmen ist eine Messung des gesamten Gasstroms nicht notwendig. Aus diesem Grund wird generell nur einen Teil des Gasstroms hinsichtlich seines Sauerstoffanteils gemessen. Hierzu wird die Sauerstoffmesszelle an einen Bypass gekoppelt, wobei ein Teil des Gassstroms dann durch den Bypass an der Sauerstoffmesszelle vorbei (auch "Bypassstrom" genannt) und der andere Teil des Gasstroms durch die Sauerstoffmesszelle strömt (auch "Diffusionsstrom" oder "Messstrom" genannt) und dort hinsichtlich seines Sauerstoffanteils gemessen wird. Der Bypass ist häufig auch in die Sauerstoffmesszelle integriert.

Bei solchen, an einen Bypass gekoppelten Sauerstoffmesszellen, wird der Gasdruck bisher stets stromaufwärts der Abzweigung zum Bypass gemessen, also vor der Teilung des Gasstroms in Bypassstrom und Diffusionsstrom.

Im Rahmen der Erfindung wurde jedoch erkannt, dass die dabei gemessenen Druckwerte nicht immer aussagekräftig sind. Denn es hat sich herausgestellt, dass die bei der vorgenannten Messmethode gemessenen Gasdrücke nicht den in der Sauerstoffmesszelle herrschenden Gasdrücken entsprechen müssen. Dies kann offenbar insbesondere dann der Fall sein, wenn die Gasleitung entlang des Diffusionsstroms gestört, beispielsweise verstopft ist. Der gemessene Gasdruck entspricht dann häufig dem Gasdruck im Bypass, nicht jedoch dem Gasdruck in der Sauerstoffmesszelle.

Der Erfindung liegt die Aufgabe zugrunde, eine Sauerstoffmesszelle der eingangs genannten Art zu Verfügung zu stellen, mit welcher genauere Werte über den in der Sauerstoffmesszelle herrschenden Gasdruck zur Verfügung gestellt werden können, als dies mit den Messmethoden nach dem Sand der Technik möglich ist.

Zur Lösung dieser Aufgabe wird erfindungsgemäß zur Verfügung gestellt eine Sauerstoffmesszelle, insbesondere eine an einen Bypass gekoppelte Sauerstoffmesszelle, mit folgenden Merkmalen:
einer Messkammer mit einem Gaseinlass und einem Gasauslass für zu analysierendes Gas;
einem in der Messkammer angeordneten hantelförmigen Drehteil mit zwei stickstoffgefüllten Hohlkörpern und einem diese verbindenden Verbindungsteil, wobei
das Drehteil um eine senkrecht zur Längsachse des Verbindungsteils verlaufenden Achse drehbar angeordnet ist;
einem an dem Drehteil angeordneten Spiegel;
einer Einrichtung zur Erzeugung eines ungleichförmigen Magnetfeldes im Bereich des Drehteils;
einem Lichtsender zur Erzeugung eines Lichtstrahls und dessen Sendung auf den Spiegel;
einem Photosensor, auf den der Lichtstrahl über den Spiegel reflektierbar ist, zur Bestimmung der Nullstellung des Drehteils;
wenigstens einer Einrichtung zur Messung des Gasdrucks in der Messkammer.

Die Erfindung beruht auf der Erkenntnis, dass ein genauer Gasdruck nur dann messbar ist, wenn der tatsächlich in der Messkammer herrschende Gasdruck gemessen wird. Zu diesem Zweck weist die erfindungsgemäße Sauerstoffmesszelle eine Einrichtung zur Messung des Gasdrucks in der Messkammer auf.

Mit der Erhöhung der Genauigkeit der Gasdruckmessung mit der erfindungsgemäßen Sauerstoffmesszelle geht auch eine Erhöhung der Genauigkeit der Sauerstoffmessung mit der Sauerstoffmesszelle einher, da letztere in Abhängigkeit des jeweils gemessenen Gasdrucks bestimmt wird.

Bevorzugt ist die erfindungsgemäße Sauerstoffmesszelle an einen Bypass gekoppelt. Durch den Bypass ist die den Gesamtgasstrom führende Gasleitung in zwei Teilleitungen aufgespalten. Durch eine Teilleitung, den Bypass, ist ein Teilstrom ("Bypassstrom") des Gesamtgasstromes an der Sauerstoffmesszelle vorbeileitbar. Durch die andere Teilleitung, die gebildet ist aus dem Gaseinlass, der dieser stromabwärts nachgeschalteten Messkammer und dem dieser stromabwärts nachgeschalteten Gasauslass, ist der verbleibende Teilstrom ("Diffusionsstrom") des Gesamtgasstromes ausschließlich durch die Sauerstoffmesszelle leitbar, wo er hinsichtlich seines Sauerstoffanteils gemessen wird. Der Bypass kann in die Sauerstoffmesszelle integriert sein.

Falls die Sauerstoffmesszelle an keinen Bypass gekoppelt ist, fließt der Gesamtgasstrom durch die aus Gaseinlass, Messkammer und Gasauslass gebildete Gasleitung.

Nach einer Ausführungsform kann die Einrichtung zur Messung des Gasdrucks in dem Gaseinlass oder in dem Gasauslass angeordnet sein, da die im Gasein- oder Gasauslass herrschenden Gasdrücke eine genaue Bestimmung beziehungsweise Messung des in der Messkammer herrschenden Gasdrucks erlauben. Es kann auch vorgesehen sein, dass eine Einrichtung zur Messung des Gasdrucks in dem Gaseinlass und eine weitere Einrichtung zur Messung des Gasdrucks in dem Gasauslass angeordnet ist. In letzterem Fall ist eine besonders genaue Messung des Gasdrucks in der Messkammer möglich.

Bevorzugt ist die Einrichtung zur Messung des Gasdrucks als integraler Bestandteil der Sauerstoffmesszelle ausgebildet ist, beispielsweise in dem durch den Deckel (bzw. oberen Flansch) der Messkammer führenden Leitungsabschnitt des Gaseinlasses oder in dem durch den Boden (bzw. unteren Flansch) der Messkammer führenden Leitungsabschnitt des Gasauslasses. Hierdurch ist gewährleistet, dass die auf eine Sauerstoffmesszelle jeweils abgestimmte Einrichtung zur Messung des Gasdrucks unvertauschbar mit der Sauerstoffmesszelle verbunden ist.

Es kann vorgesehen sein, dass im Gaseinlass, im Gasauslass oder sowohl im Gasein- als auch im Gasauslass je ein Diffusor angeordnet ist. Der Diffusor kann beispielsweise als Lochblech, als Sieb oder als Gewebe gestaltet sein. Bei der Strömung des Gases durch den Diffusor erfolgt eine Vergleichmäßigung des Gasstroms, wodurch sowohl eine optimierte Gasdruckmessung als auch eine optimierte Sauerstoffmessung durchführbar sind.

Eine in dem Gaseinlass angeordnete Einrichtung zur Messung des Gasdrucks ist bevorzugt stromaufwärts eines in dem Gaseinlass angeordneten Diffusors angeordnet, wohingegen eine in dem Gasauslass angeordnete Einrichtung zur Messung des Gasdrucks bevorzugt stromabwärts eines in dem Gasauslass angeordneten Diffusors angeordnet ist.

Durch den Diffusor wird stromaufwärts des Diffusors in dem Gaseinlass und stromabwärts des Diffusors in dem Gasauslass quasi eine Gasverteilkammer gebildet, in der sich der Gasstrom verteilt und vergleichmäßigt. Diese Gasverteilkammer kann einen gegenüber dem übrigen Leitungsquerschnitt des Gaseinlasses beziehungsweise des Gasauslasses vergrößerten Strömungsquerschnitt aufweisen und beispielsweise kammerartig gestaltet sein. Die Gasverteilkammer ist bevorzugt in dem unmittelbar stromaufwärts des Diffusors gelegenen Bereich des Gaseinlasses und in dem unmittelbar stromabwärts des Diffusors gelegenen Bereich des Gasauslasses angeordnet.

Nach einer anderen Ausführungsform ist vorgesehen, dass die Einrichtung zur Messung des Gasdrucks in der Messkammer selbst, also unmittelbar in der Messkammer angeordnet ist.

Die Art und Weise sowie der Ort der Anordnung der Einrichtung zur Messung des Gasdrucks in der Messkammer selbst sind grundsätzlich beliebig. Beispielsweise kann die Einrichtung zur Messung des Gasdrucks im Bereich des Deckels der Messkammer, im Bereich des Bodens der Messkammer oder je eine Einrichtung zur Messung des Gasdrucks sowohl im Bereich des Deckels als auch im Bereich des Bodens der Messkammer angeordnet sein. Die Anordnung zur Einrichtung zur Messung des Gasdrucks im Bereich des Deckels oder des Bodens ist insoweit vorteilhaft, als dass bei einer solchen Anordnung gewährleistet ist, dass der Strahlengang des Lichtstrahls nicht gestört wird. Auch ist die Anordnung der Einrichtung zur Messung des Gasdrucks an Deckel oder Boden der Messkammer äußerst einfach zu bewerkstelligen, da diese Bereiche manuell gut zu erreichen sind.

Grundsätzlich kann eine beliebige Einrichtung zur Messung des Gasdrucks nach dem Stand der Technik verwendet werden.

Bevorzugt wird eine Einrichtung zur Messung des Gasdrucks in Form eines Drucksensors eingesetzt. Besonders bevorzugt wird eine Einrichtung zur Messung des Gasdrucks in Form eines als Piezoelement ausgebildeten Membransensors verwendet. Entsprechende Drucksensoren haben den Vorteil, dass sie sehr geringe Abmessungen aufweisen und dennoch äußerst präzise Messergebnisse liefern. Dadurch ist es möglich, den Drucksensor vollständig in den Gaseinlass, in den Gasauslass oder in die Messkammer zu integrieren - trotz der regelmäßig nur sehr geringen Abmessungen von Messkammern - und gleichzeitig eine äußerst präzise Druckmessung durchzuführen. Auch eine Ergänzung bestehender Sauerstoffmesszellen mit solchen Drucksensoren ist ohne weiteres möglich.

Der Photosensor kann beispielsweise als Differentialphotozelle ausgebildet sein. Die Differentialphotozelle setzt sich aus zwei mit Abstand zueinander angeordneten Photozellen zusammen. In der Nullstellung des Drehteils fällt der vom Spiegel reflektierte Lichtstrahl in den Raum zwischen den beiden Photozellen. Die Nullstellung wird entsprechend dadurch bestimmt, dass die Photozellen kein Lichtsignal empfangen.

In ihrem Grundaufbau kann die erfindungsgemäße Sauerstoffmesszelle wie aus dem Stand der Technik bekannt aufgebaut sein, beispielsweise wie die Sauerstoffmesszelle gemäß DE 36 33 750 C2.

Die Sauerstoffmesszelle kann beispielsweise einen Deckel und einen Boden aufweisen, zwischen denen die Messkammer angeordnet ist. Der Deckel kann beispielsweise einen Gaseinlass und der Boden einen Gasauslass für das der Messkammer zuzuführende, zu analysierende Gas aufweisen. Deckel und Boden können jeweils aus Metall gefertigt sein.

Der Gaseinlass kann beispielsweise durch den Deckel und der Gasauslass durch den Boden der Messkammer verlaufen. Der jeweilige Diffusor kann bevorzugt in dem Leitungsabschnitt von Gaseinlass oder Gasauslass angeordnet sein, der durch den Deckel beziehungsweise den Boden verläuft.

Die auf der Gaseinlassseite der Messkammer gebildete Gasverteilkammer kann beispielsweise ganz oder teilweise in den Deckel integriert sein. Die auf der Gasauslassseite der Messkammer gebildete Gasverteilkammer kann beispielsweise ganz oder teilweise in den Boden integriert sein.

Die Messkammer kann beispielsweise zylinderförmig gestaltet sein. Bevorzugt besteht die Messkammer aus einem lichtdurchlässigen Material, beispielsweise Glas. Gegen den Deckel und den Boden kann die Messkammer abgedichtet sein, wie zum Beispiel durch elastische Dichtungsmittel, beispielsweise Dichtungsringe.

Das Drehteil kann beispielsweise zwei ballonförmige, stickstoffgefüllte Hohlkörper aufweisen, beispielsweise Glashohlkörper. Die Hohlkörper können beispielsweise durch ein stabförmiges Verbindungsteil, bevorzugt aus Metall, besonders bevorzugt aus einem magnetisierbaren Metall miteinander verbunden sein.

Der an dem Drehteil angeordnete Spiegel kann beispielsweise mittig zwischen den Hohlkörpern am Verbindungsteil angeordnet sein, beispielsweise an der Verbindungsstelle des Verbindungsteils mit einem Torsionsteil, an dem das Drehteil drehbar angeordnet ist.

Bei der Einrichtung zur Erzeugung eines ungleichförmigen Magnetfeldes im Bereich des Drehteils kann es sich bevorzugt um einen Magneten, bevorzugt um einen Elektromagneten handeln.

Bei dem Lichtsender zur Erzeugung eines Lichtstrahls kann es sich bevorzugt um eine Diode, aber beispielsweise auch um eine Lampe handeln. Die Strahlung des Lichtsenders kann mittels optischer Einrichtungen, beispielsweise Linsen, zu einem Lichtstrahl bündelbar sein.

Das Drehteil kann, wie aus dem Stand der Technik bekannt, drehbar an einem um seine Längsachse tordierbaren Torsionsteil angeordnet ist, wobei die Längsachse des Torsionsteils senkrecht zur Längsachse des Verbindungsstabes verläuft und mittig zwischen den Hohlkörpern des Drehteils mit dem Verbindungsteil verbunden ist. Bei dem Torsionsteil handelt es sich bevorzugt um ein gespanntes Seil, einen gespannten Draht oder ein Torsionsband, bevorzugt einen gespannten Metalldraht oder ein gespanntes Torsionsband, welcher beziehungsweise welches um seine Längsachse tordierbar ist.

In der Messkammer kann ferner eine von einem elektrischen Strom durchfließbare Leiterschleife angeordnet sein, durch die ein Drehmoment auf das Drehteil ausübbar ist. Insbesondere kann die Leiterschleife derart von elektrischem Strom durchfließbar sein, dass ein derartiges Drehmoment auf das Drehteil ausübbar ist, dass die durch Sauerstoffgas ausgeübte Auslenkung des Drehteils durch die Leiterschleife kompensierbar und das Drehteil wieder in seine Nullstellung rückdrehbar ist. Die Leiterschleife kann an ein Strommessinstrument zur Messung des durch die Leiterschleife fließenden Stroms gekoppelt sein.

Bei einem Verfahren zur Bestimmung des Gasdrucks in der erfindungsgemäßen Sauerstoffmesszelle wird der Gasdruck in der Messkammer der Sauerstoffmesszelle mittels der Einrichtung zur Messung des Gasdrucks in der Messkammer der Sauerstoffmesszelle gemessen.

Weitere Merkmale der Erfindung ergeben sich aus den Figuren und den Unteransprüchen.

Ein Ausführungsbeispiel der erfindungsgemäßen Sauerstoffmesszelle soll anhand der nachfolgenden Figurenbeschreibung näher erläutert werden.

Dabei zeigt
- Fig. 1: eine Seitenansicht einer erfindungsgemäßen Sauerstoffmesszelle mit Gehäuse;
- Fig. 2: eine Vorderansicht der Sauerstoffmesszelle nach Figur 1 und
- Fig. 3: eine Schnittansicht entlang der Schnittlinie A-A gemäß Figur 2.

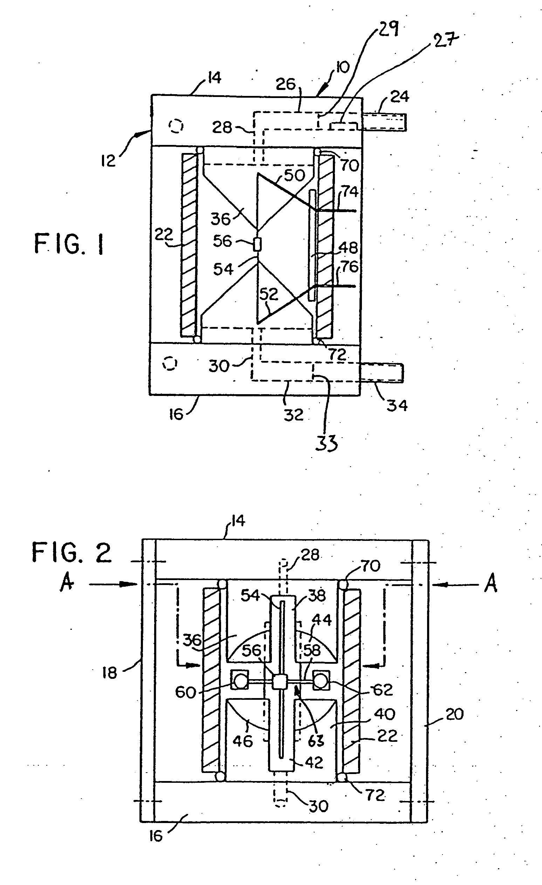

Die in den Figuren 1 bis 3 dargestellte Messzelle 10 weist ein Gehäuse 12 mit einem Deckel 14, einem Boden 16 und zwei Seitenwänden 18 und 20 auf. Nach vorne und hinten ist das Gehäuse 12 offen.

Zu analysierendes Gas wird über einen Gaseinlassstutzen 24 eines Gaseinlasses 26 zugeführt, der am Deckel 14 angebracht ist. Im Inneren des Deckels 14 setzt sich der Gaseinlass 26 zunächst in einem horizontal verlaufenden Abschnitt fort, der schließlich in einem senkrecht nach unten abknickenden Abschnitt an einer Mündung 28 in die Messkammer 22 mündet. Der Mündung 28 gegenüberliegend ist im Boden 16 des Gehäuses 12 eine Mündung 30 angeordnet, die mit einem Gasauslass 32 verbunden ist, die wiederum an einem Gasauslassstutzen 34 nach außen führt.

Die Messkammer 22 ist als Hohlzylinder aus Glas ausgebildet und an ihren beiden Enden offen.

In dem Gaseinlass 26 ist eine Einrichtung zur Messung des Gasdrucks in der Messkammer 22 in Form eines als Piezoelement ausgestalteten Membransensors 27 angeordnet. Stromabwärts des Membransensors 27 ist ein Diffusor 29 in Form eines Siebes aus Metall in dem Gaseinlass 26 angeordnet.

In dem Gasauslass 32 ist ebenfalls ein entsprechender Diffusor 33 angeordnet.

Der Gaseinlass 26 ist die stromabwärts einer zu einem Bypass (nicht dargestellt) führenden Leitungsabzweigung gelegene Leitung. Der Bypass überbrückt die Sauerstoffmesszelle 10. Der Gasauslass 32 führt zum Ausgang des Bypasses.

In der Messkammer 22 sind ein oberes Polstück 36 mit einer Aussparung 38 und ein gegenüberliegendes unteres Polstück 40 mit einer der oberen Aussparung 38 gegenüberliegenden Aussparung 42 angeordnet. Das obere Polstück 36 ist mit einer oberen Schrägfläche 44 versehen und entsprechend das untere Polstück 40 mit einer unteren Schrägfläche 46. Die Schrägflächen 44, 46 liegen einander gegenüber. Zwischen den Endkanten der Schrägflächen 44, 46 ist ein inhomogenes Magnetfeld erzeugbar, aufgrund außen angebrachter Magnete, die auf die aus Weicheisen bestehende Polstücke 36, 40 einwirken.

An einem Abschnitt der Innenwand der Messkammer 22 ist eine längliche Halteplatte 48 angeordnet. Von der Halteplatte 48 springen ins Innere der Messkammer 22 je ein oberer Tragarm 50 und ein unterer Tragarm 52. Die Tragarme 50, 52 reichen jeweils von der Halteplatte 48 bis zur zentralen Längsachse der Messkammer 22. Zwischen den Enden der Tragarme 50, 52 ist ein Torsionsteil in Form eines Torsionsbandes 54 aus einer Platin-Rhodium-Legierung gespannt.

Wie besonders aus Figur 2 deutlich wird, ist in der Mitte des Torsionsbandes 54 ein stabförmiges Verbindungsteil 58 mittig befestigt, an dessen Enden je ein Hohlkörper in Form eines Gasballons 60, 62 angeordnet ist. Die Gasballons 60, 62 sind mit Stickstoff gefüllt und hermetisch abgedichtet.

Weiterhin ist an der Verbindungsstelle zwischen Verbindungsstab 58 und Torsionsband 54 ein Spiegel 56 angeordnet.

Das Verbindungsteil 58 sowie die Gasballons 60, 62 bilden das Drehteil 63.

Der die Messkammer bildende Glaszylinder 22 ist, wie besonders aus Figur 1 und 2 hervorgeht, endseitig gegen den Deckel 14 des Gehäuses 12 über einen elastischen O-Ring 70 und am gegenüberliegenden Ende gegen den Boden 16 des Gehäuses 12 über einen entsprechenden O-Ring 72 abgedichtet.

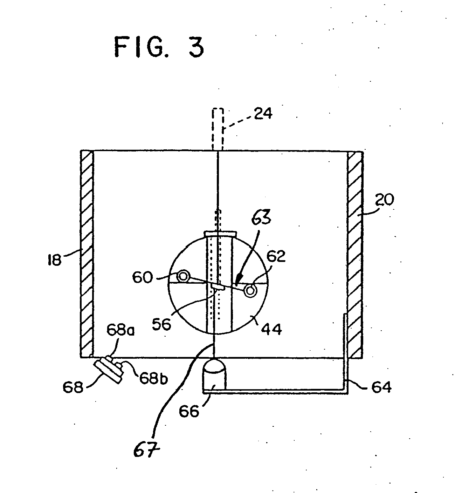

Die Anordnung der Messzelle 22 und deren Funktion werden besonders aus der Aufsicht auf einen Horizontalschnitt der Messzelle gemäß Figur 3 deutlich. Das Drehteil 63 mit den beiden jeweils an den Enden des Verbindungsteils 58 angeordneten Gasballonen 60, 62 trägt in der Mitte des Verbindungsteils 58 den Spiegel 56, auf den ein Lichtstrahl 67 fällt, der von einer Lampe 66 ausgesandt wird, die über einen Halter 64 an der Seitenwand 20 des Gehäuses 12 befestigt ist. Der Lichtstrahl 67 wird am Spiegel 56 reflektiert und, je nach Verdrillung des Torsionsbandes 54 (vergleiche Figur 2), in einem bestimmten Winkel zur Richtung Lampe-Torsionsband wieder nach außen geschickt. Der reflektierte Lichtstrahl gelangt über die Wand der Messkammer 22 wieder nach außen und kann dort mit Hilfe eines als Photozelle 68 ausgebildeten Photosensors registriert werden. Die Justierung der Nullstellung des Spiegels 56 beziehungsweise des Drehteils 63 kann einfach durch Verdrehen des Glaszylinders 22 erfolgen.

Die Photozelle 68 ist, wie in Figur 3 angedeutet, als Differentialphotozelle ausgebildet, enthält also eine (linke) Photozelle 68a und (rechte) Photozelle 68b.

Eine Leiterschleife umgibt das Drehteil 63 unmittelbar benachbart zu den Gasballons 60, 62 des Drehteils 63. Der Verlauf der Leiterschleife wird anhand der jeweils rechtwinklig abknickenden, die Gasballons 60, 62 benachbart umgebenden Abschnitte angenähert deutlich, wie sie in Figur 2 dargestellt sind. Zur Stromzuführung zur Leiterschleife dienen Stifte 74, 76, die die Halteplatte 48 und die Messkammerwand 22 durchragen und zur Leiterschleife führen.

Die Photozelle 68 wird so angeordnet, dass sich in Ruhelage beziehungsweise Nullstellung des Drehteils 63, also wenn auf dieses kein Drehmoment ausgeübt wird, der reflektierte Lichtstrahl genau in der Mitte zwischen den zwei Photozellen 68a, 68b befindet. Aus dieser Nullstellung heraus wird, wenn Sauerstoff in die Messkammer 22 gelangt, das Drehteil mit einem bestimmten Drehmoment ausgelenkt, das proportional zur Sauerstoffkonzentration des in die Messkammer 22 eingeleiteten Gases ist. Demzufolge bewegt sich der an dem Verbindungsteil 58 des Drehteils 63 befestigte Spiegel 56 mit und dies führt zu einer Auslenkung des vom Spiegel 56 reflektierten Lichtstrahls, der nunmehr nicht mehr zwischen den beiden Photozellen 68a, 68b auftrifft, sondern etwas daneben, beispielsweise auf die Photozelle 68a. Diese sendet ein Steuersignal ab, mit dem die an der Kompensations-Leiterschleife anliegende Spannung und damit der durch die Leiterschleife führende Strom erhöht wird, wodurch eine Magnetfeldstärke erzeugt wird, die dem durch die Sauerstoffkonzentration erzeugten Drehmoment des Drehteils 63 entgegenwirkt. Die Spannung wird solange erhöht, bis die Photozelle 68a nicht mehr von dem reflektierten Lichtstrahl getroffen wird und der Lichtstrahl daher wieder zwischen den beiden Photozellen 68a, 68b auftrifft.

Die Kompensationsspannung an der Leiterschleife ist dann ein direktes Maß für die Sauerstoffkonzentration. Entsprechendes gilt für eine gegensinnige Auslenkung des Lichtstrahls, etwa von der Nulllage hin zur Photozelle 68b.

## Patentansprüche

1. Sauerstoffmesszelle mit folgenden Merkmalen:
a. einer Messkammer (22) mit einem Gaseinlass (26) und einem Gasauslass (32) für zu analysierendes Gas;
b. einem in der Messkammer (22) angeordneten hantelförmigen Drehteil (63) mit zwei stickstoffgefüllten Hohlkörpern (60, 62) und einem diese verbindenden Verbindungsteil (58), wobei
c. das Drehteil (63) um eine senkrecht zur Längsachse des Verbindungsteils (58) verlaufenden Achse drehbar angeordnet ist;
d. einem an dem Drehteil (63) angeordneten Spiegel (56);
e. einer Einrichtung zur Erzeugung eines ungleichförmigen Magnetfeldes im Bereich des Drehteils (63);
f. einem Lichtsender (66) zur Erzeugung eines Lichtstrahls (67) und dessen Sendung auf den Spiegel (56);
g. einem Photosensor (68a, 68b), auf den der Lichtstrahl (67) über den Spiegel (56) reflektierbar ist, zur Einstellung der Nullstellung des Drehteils (63);
h. wenigstens einer Einrichtung (27) zur Messung des Gasdrucks in der Messkammer (22).

2. Sauerstoffmesszelle Anspruch 1, bei der die Einrichtung (27) zur Messung des Gasdrucks in dem Gaseinlass angeordnet ist.

3. Sauerstoffmesszelle Anspruch 1, bei der die Einrichtung (27) zur Messung des Gasdrucks stromaufwärts eines in dem Gaseinlass (26) angeordneten Diffusors (29) angeordnet ist.

4. Sauerstoffmesszelle Anspruch 1, bei der die Einrichtung zur Messung des Gasdrucks in dem Gasauslass (32) angeordnet ist.

5. Sauerstoffmesszelle Anspruch 1, bei der die Einrichtung zur Messung des Gasdrucks stromabwärts eines in dem Gasauslass (32) angeordneten Diffusors (33) angeordnet ist.

6. Sauerstoffmesszelle Anspruch 1, bei der die Einrichtung (27) zur Messung des Gasdrucks in der Messkammer (22) selbst angeordnet ist.

7. Sauerstoffmesszelle nach Anspruch 1 mit einer Einrichtung (27) zur Messung des Gasdrucks in Form eines als Piezoelement ausgestalteten Membransensors.

8. Sauerstoffmesszelle nach Anspruch 1, wobei das Drehteil (63) drehbar an einem um seine Längsachse tordierbaren Torsionsteil (54) angeordnet ist, wobei die Längsachse des Torsionsteils (54) senkrecht zur Längsachse des Verbindungsteils (58) verläuft und mittig zwischen den Hohlkörpern (60, 62) des Drehteils (63) mit dem Verbindungsteil (58) verbunden ist.

9. Verfahren zur Bestimmung des Gasdrucks in einer Sauerstoffmesszelle nach Anspruch 1, bei dem der Gasdruck mittels der Einrichtung (27) zur Messung des Gasdrucks in der Messkammer (22) der Sauerstoffmesszelle gemessen wird.
